# EUROPEAN PATENT SPECIFICATION

(11) **EP 2 705 522 B1**
(45) Date of publication and mention of the grant of the patent: **28.06.2017**
(21) Application number: 12719954.5
(22) Date of filing: 03.05.2012
(51) Int. Cl.: H01J 37/34, H01J 37/32, C23C 14/32, C23C 14/34

(54) **GLOW DISCHARGE APPARATUS AND METHOD WITH LATERAL ROTATING ARC CATHODES**
GLIMMENTLADUNGSVORRICHTUNG UND VERFAHREN MIT SEITLICH ROTIERENDEN LICHTBOGENKATHODEN
APPAREIL DÉCHARGE LUMINESCENTE ET PROCÉDÉ DE CATHODES À ARC À ROTATION LATÉRALE

(30) Priority: 06.05.2011 EP 11165152
(43) Date of publication of application: 12.03.2014
(73) Proprietor: Pivot A.S., 78701 Sumperk (CZ)
(72) Inventor: CSELLE, Tibor, CH-4515 Oberdorf (CH); MOJMIR, Jilek, 78701 Sumperk (CZ); LÜMKEMANN, Andreas, 4512 Bellach (CH)
(74) Representative: Schmauder & Partner AG Patent- & Markenanwälte VSP
(86) International application number: PCT/EP2012/058092
(87) International publication number: WO 2012/152642

(56) References cited:
- EP-A1- 0 462 303
- EP-A1- 1 357 577
- WO-A1-02/50865
- WO-A2-2008/008717
- US-A- 5 294 322
- US-A1- 2005 109 616
- US-A1- 2008 318 069

## Description

### Field of invention

The invention is related to a particular glow discharge apparatus and a corresponding method, which can be used in a special Physical Vapor Deposition (PVD) coating apparatus with Lateral Rotating Arc cathodes which are known as LARC^{®}.

The cathodes should be equipped with rotating shields, as shutters.

### Background of invention

An electric glow discharge is a plasma process formed by the passage of current at 100V to several kV through a gas at low pressure, such as argon or another noble gas.

Because of a so called antenna effect the conventional glow discharge burns preferentially around sharp edges, but sometimes also inside holes. The conditions sharply depend on the pressure, substrate bias, chamber volume, loading, etc. Therefore, it is practically impossible to clean the substrate surface uniformly using conventional glow discharge. Optimization of the conventional glow discharge is difficult and sometimes even impossible.

These difficulties can be reduced by the "arc-enhanced glow discharge" method, disclosed by US 5 294 322 A and by the paper "Arc-enhanced glow discharge in vacuum machines" by J. Vetter et al. in Surface and Coating Technology No. 59 (1993), pages 152 to 155. However, the device of US 5 294 322 A needs an additional ionization anode, which must be kept clean and needs maintenance between two processes. There is also a risk of hard-arc burning on the substrates.

Additional background information according to the Lateral Rotating Arc cathodes (LARC) is disclosed in the EP 1173629 A1, EP 1 356 496 A1, EP 1 357 577 A1, EP 1 524 329 A1, und EP 1 673 488 A2.

US2008/031809 A1 discloses a hard, wear-resistant Aluminum Nitride based coating produced by a two-cathode system. In WO 2005/100635 A1 an apparatus for deposition of coatings on samples or substrates is disclosed comprising a vacuum chamber of coating apparatus with inlet of reactive and inert gases, two rotating electrodes galvanically separated from the rest of the coating apparatus, connected to the positive pole of a current supply (11).

In US 2005/0 109 616 A1 a sputtering apparatus is disclosed for applying a thin film coating to a substrate containing, in a vacuum chamber, at least two cylindrical targets and at least two magnets each juxtaposed to one of the targets so as to generate a magnetic field in a vicinity of an outer surface of the target.

In EP 0 462 303 B1 a vacuum arc deposition device is disclosed having electrode switching means comprising two or more electrodes consisting of vacuum arc vapor evaporation source materials and a substrate to which films are formed by means of vacuum arc vapor deposition, each of the electrodes and the substrate being contained in a vacuum chamber capable of introducing a reactive gas, wherein the electrodes are connected to arc discharging DC power supplies by way of polarity switching means so that each of the electrodes functions as a cathode and an anode alternately.

### Description of the invention

One object of the invention is to provide an apparatus for improving the above mentioned process using a Lateral Rotating Arc cathode (LARC) cathode acting as the anode, which can be cleaned immediately after the arc enhanced glow discharge, in-situ burning behind the shutter. This object of the invention is solved by the inventive method according to claim 1. Another object of the invention is to improve the corresponding process. This object of the invention is solved by the inventive method according to claim 10. The measures of the invention have primarily the effect that - for the production of Ar⁺ ions by arc-enchanced glow discharge processes as alternative method to a conventional Ar-glow discharge process - the ions are produced by inelastic collisions of electrons generated in arc and gas atoms.

In order to generate electrons the system uses two rotary cylindrical electrodes equipped with rotary shields. One of the two cathodes is switched from negative pole of low voltage arc supply - the configuration used for the deposition of layers - to positive pole of current supply and creates therewith an ionization anode. This ionization anode in combination with the second cylindrical rotary cathode connected to a negative pole of low voltage arc supply in combination with use of the closed rotary shield, so that the second cathode is shielded from the samples, forms effective ionization supply. It is advantageous if the current supply connected to the ionization anode operates in pulse regime. It substantially improves stability of the arc-enhanced glow discharge process and eliminates formation of arc discharge on substrates.

By the higher electron current a higher ionization degree is achieved. In an arc-enhanced glow discharge process a better homogeneity of ion etching can be achieved at different positions in chamber and, therefore, the capability of etching effects for complicated substrate geometries is enhanced. The Risk of micro-arcs is decreased by use of pulsed current source as current supply to ionization anode. After the arc-enhanced glow discharge process it is very easy to remove contaminations in-situ from the cylindrical rotary electrode, which was acting as ionization anode. Contaminations caused by resputtering processes will be removed when switching the electrode from anode mode back to cathode mode, i.e. the coating deposition mode. Closing the shutter during this cathode cleaning step avoids the tools being coated.

Further advantageous details of the inventive methods are defined in the dependent claims.

The abovementioned elements and also the elements to be used according to the invention and claimed and described in the following exemplary embodiments are - beyond the explicit definitions of the claims - subject to no particular exceptions in terms of their size, shaping, use of material and their technical design, and so the selection criteria known in the respective field of use can be used in an unrestricted manner.

### Brief description of the drawings

Exemplary embodiments of the invention will be described in more detail below with reference to drawings, in which
- Figure 1: shows a schematic arrangement of the elements according to the preferred embodiment of the invention; as it is used for the arc-enhanced glow discharge process;
- Figure 2: shows a schematic arrangement of the elements according to the preferred embodiment of the invention as it is used for thin film coating step;

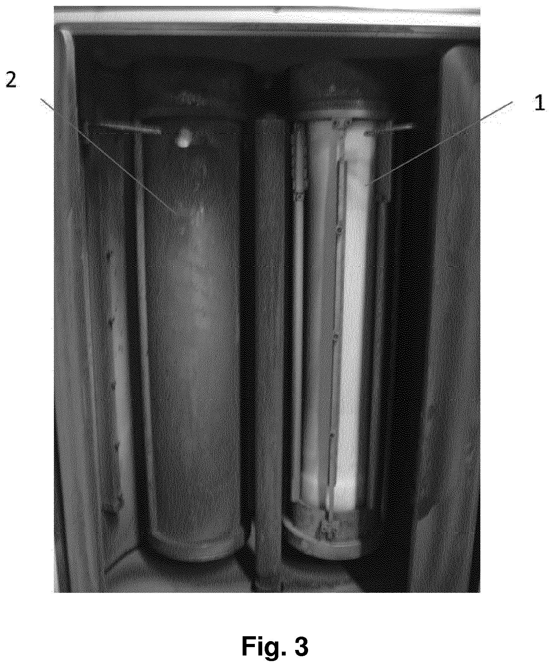

- Figure 3: shows a photographic picture of the cathode configuration according to the arrangement of figure 1;
- Figure 4: shows a comparison between different glow discharge methods, wherein 4a shows process according to the prior art and 4b shows the process according to the instant invention;
- Figure 5: Adhesion improvement of the coating and therefore tool life improvement of milling inserts with the help of the LARC Glow Discharge, with 5a a photo of the tool and 5b a quantitative diagram of the improvement;
- Figure 6: Removal of residual materials after pretreatment with glass beads blasting and therefore adhesion and tool life improvement of HSS end mills with the help of the LARC Glow Discharge, with 6a a photo of the tool and 6b a quantitative diagram of the improvement.

### Description of preferred embodiment

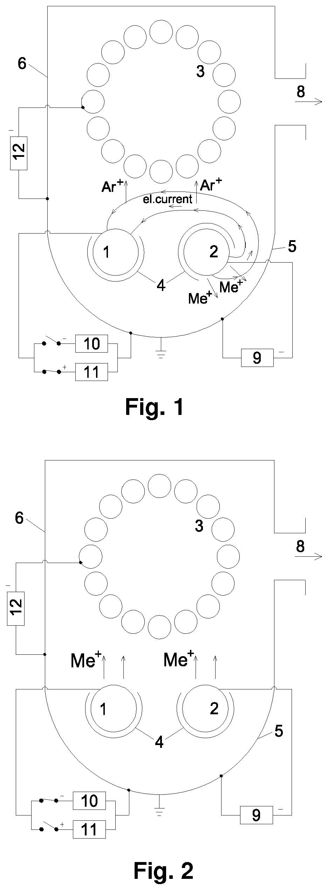

In the chamber 6 of the Physical Vapor Deposition (PVD) apparatus shown in figure 1, there are two electrodes (cathodes) 1 and 2. While the second cathode 2 is implemented by Ti - alternatively by Cr, TiAl or TiSi - target, the first electrode 1 is equipped by Aluminum target - alternatively AlSi, AlTi, AlCr. Cathode 1 is designed as an electrode which is used alternatively as anode for the LARC glow discharge process and as cathode for the coating deposition.

The cathodes are designed to have rotatable shields 4, as shutters. The shutters are rotatable steel sheets, shields between the cathode and the substrates. The aim of the shutters is avoiding pollution, contaminating the substrates while igniting the ARC of the cathode. They do avoid the evaporated target contamination being deposited onto the substrates.

The chamber is connected to a turbo pump via the outlet 8.

The cathodes (targets) 1 and 2 are supplied by the standard arc sources 9 and 10. The electrode 1 is additionally supplied by the pulse current source 11. The standard arc source 10 and the pulsed current source 11 can be switched to the electrode 1 selectively.

A bias 12 is connected between the chamber wall and the substrates 3.

In the preferred embodiment the invention is performed by the following steps: The shield on the second cathode 2 is closed. The respective arc burns directly to the door (to the back). The process is - in the described example - executed with arc current 100A and -20 V. The gas in the process according to this embodiment is Ar or combination of ArH. The rotary shield on the first electrode 1 is opened. A positive potential is applied on the first electrode 1. In the described example the positive potential is in the range of +0 to +50V. In this mode the first electrode 1 is the anode of the process. Accordingly an electrical potential of 20 to 70V is applied between the electrodes.

The electron stream does not burn only against the door because the potential against the door is only 20V. The electrons will also be attracted by the higher potential to the first electrode 1. While those attracted electrons are travelling from the second cathode 2 to electrode 1 ionize the gas in the chamber on their path. The schematic view of this process step is embodied in Fig.1. The magnetic field of the electrode 1 supports ionizing the Ar-gas. The ionization level does not depend significantly on working pressure and substrate bias as long low pressure and low substrate bias are applied, so conventional glow discharge does not burn. The low pressure, in the described process approximately 1 Pa - and the low bias, in the described process approximately 300A - ensure that the ionized Ar gas uniformly bombards the whole substrate surface. Conventional glow discharge does not burn at these conditions, since the Ar gas ionization depends on the load, the chamber volume, the tool shape etc.

When deposition step comes to place, electrode 1 is connected to low voltage arc source 10, both shutters are opened. Both electrodes 1 and 2 can be evaporated towards substrates 3 to form required coating. Schematic view of this process step is embodied in Fig.2.

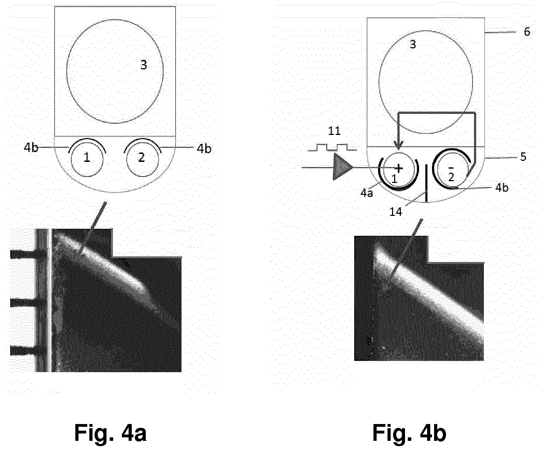

The advantage of the method according to the instant invention is demonstrated in figure 4. In figure 4a there is a conventional Ar-etching shown with metal ion etching. In figure 4b a Glow Discharge with rotating cathodes and shields is shown (U_{bias} =300V). In figure 4a the reference 1 is a anode at positive potential. In figure 4b an additional fix shutter (shield) 14 and a door 5 is shown. The photo of the state of the art result shows plaques (peeling) of approx. 0.45 mm², whereas no such peeling is present according to the embodiment of the instant invention. Figures 4a and 4b clearly demonstrate that the adhesion of the coating and the tool life of cutting tools can be improved when using the LARC Glow Discharge method according to the invention.

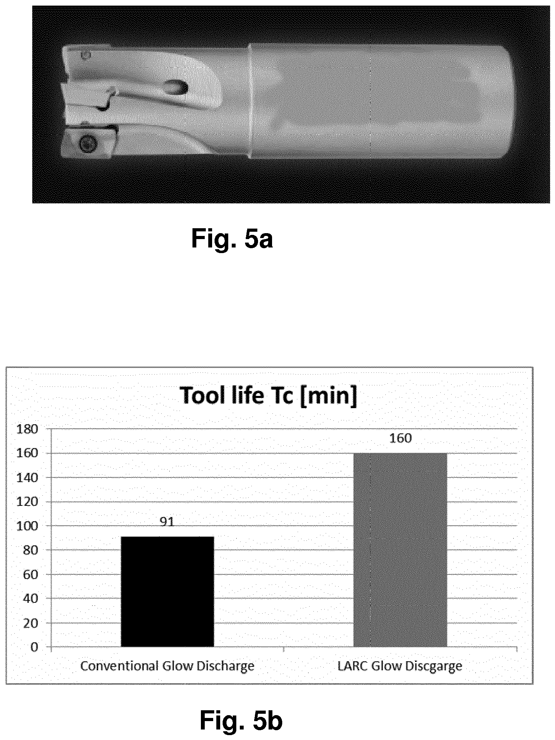

The Adhesion improvement of the coating and therefore tool life improvement of milling inserts with the help of the LARC Glow Discharge as shown in Fig. 5a and 5b (a photo of the tool and a quantitative diagram of the improvement) with the following process parameters:
Tool - insert ADMX 11T308SR
Speed - 80m/min
Work piece material -C45
Feed - 0,1mm
Depth - 8mm
ae - 22mm
Dia of the mill - 25mm
Cooling - emulsion
TiAlN + Conventional Glow Discharge - 91 min
TiAlN + LARC Glow Discharge - 160 min

If the anode is placed on the opposite side in the chamber to the ARC cathode, the anode is shadowed by the carousel and the etching efficiency is highly depending on the load of carousel.

As an important feature the LARC Glow discharge process is able to remove residual materials from the surface of the substrates, like glass sticking on the surface after glass beads blasting, diamond pastes etc., without applying any additional cleaning step (chemically or manually) as it was necessary with the conventional glow discharge.

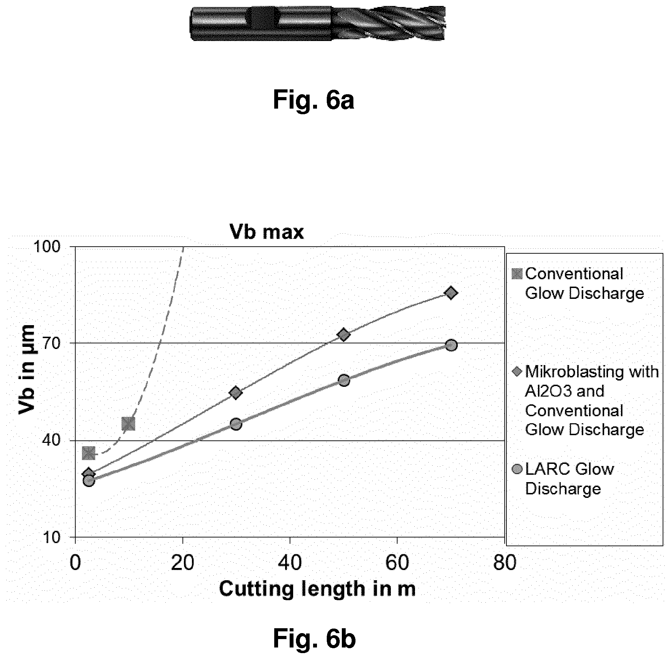

In Figure 6 the removal of residual materials after pretreatment with glass beads blasting and therefore adhesion and tool life improvement of HSS end mills with the help of the LARC Glow Discharge is shown, with 6a a photo of the tool and 6b a quantitative diagram of the improvement, with the following process parameters:

| | |
|---|---|
| Tool | Typ N 300 |
| Diameter | 16mm |
| No. of cutting etches | 4 |
| Material | 1.2312 |
| Strength | 1000 N/mm² |
| Apparatus | Deckel/Maho |
| Cutting values | vc = 100 m/min |
| | n = 1990 U/min |
| | fz = 0,08 mm |
| | vf = 636 mm/min |
| | ae = 0.2 mm |
| | ap = 24 mm |
| | Vb; Wear on the clearance |

### List of reference signs

- 1: first electrode (Al) which is used alternatively as anode for LARC glow discharge process and as cathode for the coating deposition
- 2: second cathode (Ti or Cr)
- 3: substrates
- 4: rotating shields
- 4a: open rotating shield
- 4b: closed rotating shied
- 5: door
- 6: vacuum chamber
- 8: outlet by turbo pump
- 9: low voltage arc source
- 10: low voltage arc souce
- 11: pulsed current source
- 12: bias
- 14: fixed shutter

## Claims

1. Apparatus for deposition of coatings on samples or substrates by PVD method, comprising
- a vacuum chamber of coating apparatus with inlet of reactive and inert gases;
- a first rotating electrode (1) galvanically separated from the rest of the coating apparatus, connected to a current supply (11);
- a second rotating electrode (2) galvanically separated from the rest of the coating apparatus, connected to the negative pole of a low voltage arc supply (9); said second electrode being consumed by the arc;
- said first rotating electrode (1) and said second rotating electrode (2) each are equipped with a shield (4); and that
- said apparatus further comprising a high voltage supply (12) wherein the negative pole of which is connected to the samples or substrates;
**characterized in that**
the first rotating electrode (1) is connected to the positive pole of the current supply (11) and said shields (4) are rotary shields.

2. Apparatus according to claim 1, **characterized in that** the negative pole of said current supply (11) is connected to the vacuum chamber of the coating apparatus.

3. Apparatus according to claim 1, **characterized in that** the positive pole of said low voltage arc supply (9) is connected to the vacuum chamber of the coating apparatus.

4. Apparatus according to claim 1, **characterized in that** the positive pole of said high voltage supply (12) is connected to the vacuum chamber of the coating apparatus.

5. Apparatus according to claim 1, **characterized in that** the current supply (11) is a pulse supply.

6. Apparatus according to claims 1 to 5, **characterized in that** the rotary shield of the second rotating electrode (2) is provided to shield said electrode towards the samples or substrates during the arc burning upon it.

7. Apparatus according to claims 1 to 5, **characterized in that** the rotary shield of the first electrode (1) is provided not to shield said electrode towards the samples or substrates during the arc burning and is usable for deposition of coatings on samples or substrates.

8. Apparatus according to claims 1 to 5, **characterized in that** the first rotating electrode (1) connected to the positive pole of the current supply is alternatively reconnectable to a negative pole of another low voltage arc supply (10) and is usable for deposition of coatings on samples or substrates.

9. Apparatus according to claim 5 or to claims 6 to 8 when claims 6 to 8 depend on claim 5, **characterized in that** the pulse current supply (11) is provided to generate the pulses with the length of 0,1 to 0,000001s and switching frequency of 10 to 10⁶ Hz.

10. A glow discharge method in a Physical Vapor Deposition (PVD) coating apparatus according to claims 1 to 9, said apparatus having a door, said method comprising the steps of
- operating the apparatus so that the arc of said second electrode (2) burns directly to said door in the virtual shutter mode, wherein said shield on a first electrode (1) is open and said shield (4) on a second electrode (2) is closed
- applying a positive potential on said first electrode (1), so that a potential between said electrode target (2) and said first electrode (1) is applied,
wherein said positive potential applied on said first electrode (1) is selected so that the electron stream does not burn against the door anymore since the electrons being effected by the higher potential to said first electrode (1).

11. The method according to claim 10, **characterized in that** said operation of the apparatus by which the arc of said second electrode burns directly to said door in the virtual shutter mode is performed with approximately -20V and 100A.

12. The method according to claim 10 or 11, **characterized in that** said positive potential applied on said first electrode (1) is approximately 1 to 50 V so that said potential between said second electrode (2) and said first electrode (1) is approximately 20 to 50 V.

13. The method according to any of the proceeding claims 10 to 12, **characterized in that** said first electrode (1) is a aluminum target, said second electrode (2) is a Titanium target and the processing gas in the apparatus is Argon.

14. The method according to any of the proceeding claims 10 to 13, **characterized in that** the rotary shield of the second rotating electrode (2) is arranged by turning to shield said electrode towards the samples or substrates during the arc burning upon it and that the rotary shield of the first rotating electrode (1) is arranged by turning not to shield said electrode towards the samples or substrates during the arc burning, thereby deposing coatings on samples or substrates.

## Patentansprüche

1. Vorrichtung zum Abscheiden von Beschichtungen auf Proben oder Substraten mittels PVD-Verfahren, umfassend
- eine Vakuumkammer der Beschichtungsvorrichtung mit einem Einlass für reaktive und inerte Gase;
- eine erste, vom Rest der Beschichtungsvorrichtung galvanisch getrennte, rotierende Elektrode (1), die mit dem positiven Pol einer Stromquelle (11) verbunden ist;
- eine zweite, vom Rest der Beschichtungsvorrichtung galvanisch getrennte, rotierende Elektrode (2),
**dadurch gekennzeichnet, dass**
- die besagte erste rotierende Elektrode (1) und die besagte zweite rotierende Elektrode (2) jeweils mit einem Drehschild (4) ausgestattet sind; und dass
- die besagte Vorrichtung weiterhin eine Hochspannungsquelle (12) umfasst,
wobei deren negativer Pol mit den Proben oder Substraten verbunden ist und wobei der negative Pol einer Niederspannungsbogenquelle (9) mit der besagten zweiten rotierenden Elektrode (2) verbunden ist, wobei die besagte zweite Elektrode durch einen Lichtbogen verbraucht wird.

2. Vorrichtung nach Anspruch 1, **dadurch gekennzeichnet, dass** der negative Pol der besagten Stromquelle (11) mit der Vakuumkammer der Beschichtungsvorrichtung verbunden ist.

3. Vorrichtung nach Anspruch 1, **dadurch gekennzeichnet, dass** der positive Pol der besagten Niederspannungsbogenquelle (9) mit der Vakuumkammer der Beschichtungsvorrichtung verbunden ist.

4. Vorrichtung nach Anspruch 1, **dadurch gekennzeichnet, dass** der positive Pol der besagten Hochspannungsquelle (12) mit der Vakuumkammer der Beschichtungsvorrichtung verbunden ist.

5. Vorrichtung nach Anspruch 1, **dadurch gekennzeichnet, dass** die Stromquelle (11) eine Pulsquelle ist.

6. Vorrichtung nach den Ansprüchen 1 bis 5, **dadurch gekennzeichnet, dass** das Drehschild der zweiten rotierenden Elektrode (2) zum Abschirmen der besagten Elektrode gegen die Proben oder Substrate während der darauf einwirkenden Bogenbrennung konfiguriert ist.

7. Vorrichtung nach den Ansprüchen 1 bis 5, **dadurch gekennzeichnet, dass** das Drehschild der ersten Elektrode (1) nicht zum Abschirmen der besagten Elektrode gegen die Proben oder Substrate während der Bogenbrennung konfiguriert ist und dass es zum Abscheiden von Beschichtungen auf Proben oder Substraten verwendbar ist.

8. Vorrichtung nach den Ansprüchen 1 bis 5, **dadurch gekennzeichnet, dass** die erste rotierende Elektrode (1), die mit dem positiven Pol der Stromquelle verbunden ist, alternativ mit einem negativen Pol einer anderen Niederspannungsbogenquelle (10) wiederverbindbar ist und zum Abscheiden von Beschichtungen auf Proben oder Substraten verwendbar ist.

9. Vorrichtung nach Anspruch 5 oder nach den Ansprüchen 6 bis 8 sofern die Ansprüche 6 bis 8 von Anspruch 5 abhängen, **dadurch gekennzeichnet, dass** die Puls-Stromquelle (11) zum Erzeugen der Pulse mit Länge von 0,1 bis 0,000001s und Schaltungsfrequenz von 10 bis 10⁶ Hz konfiguriert ist.

10. Ein Glimmentladungsverfahren in einer physikalischen Gasphasenabscheidungs (PVD)- vorrichtung nach den Ansprüchen 1 bis 9, wobei die besagte Vorrichtung eine Tür aufweist, und wobei das besagte Verfahren die Schritte umfasst:
- Betreiben der Vorrichtung derart, dass der Lichtbogen von der besagen zweiten Elektrode (2) direkt auf die besagte Tür im Virtuell-Verschluss Modus brennt, wobei das besagte Schild bezüglich einer ersten Elektrode (1) geöffnet ist und das besagte Schild (4) bezüglich einer zweiten Elektrode (2) geschlossen ist
- Anlegen eines positiven Potentials auf die besagte erste Elektrode (1) derart, dass ein Potential zwischen dem besagten Elektrodentarget (2) und der besagten ersten Elektrode (1) anliegt,
wobei das auf die besagte erste Elektrode (1) angelegte positive Potential so gewählt wird, dass der Elektronenstrom nicht mehr gegen die Tür brennt, weil die Elektronen durch das höhere Potential an der besagten ersten Elektrode (1) beeinflusst werden.

11. Verfahren nach Anspruch 10, **dadurch gekennzeichnet, dass** das besagte Betreiben der Vorrichtung, bei dem der Lichtbogen von der besagten zweiten Elektrode direkt auf die besagte Tür im Virtuell-Verschluss Modus brennt, mit ungefähr -20V und 100 A ausgeführt wird.

12. Verfahren nach Anspruch 10 oder 11, **dadurch gekennzeichnet, dass** das auf die besagte erste Elektrode (1) angelegte positive Potential ungefähr 1 bis 50 V ist, sodass das besagte Potential zwischen der besagten zweiten Elektrode (2) und der besagten ersten Elektrode (1) ungefähr 20 bis 50 V ist.

13. Verfahren nach irgendeinem der vorangehenden Ansprüche 10 bis 12, **dadurch gekennzeichnet, dass** die besagte erste Elektrode (1) ein Aluminium-Target ist, die besagte zweite Elektrode (2) ein Titan-Target ist und das Prozessgas in der Vorrichtung Argon ist.

14. Verfahren nach irgendeinem der vorangehenden Ansprüche 10 bis 13, **dadurch gekennzeichnet, dass** das Drehschild der zweiten rotierenden Elektrode (2) durch Drehen zum Abschirmen der besagten Elektrode gegen die Proben oder Substrate während der darauf einwirkenden Bogenbrennung positioniert wird und dass das Drehschild der ersten rotierenden Elektrode (1) durch Drehen zum Nicht-Abschirmen der besagten Elektrode gegen die Proben oder Substrate während der Bogenbrennung positioniert wird, wodurch Beschichtungen auf Proben oder Substrate abgeschieden werden.

## Revendications

1. Appareil permettant de déposer des revêtements sur des échantillons ou des substrats par le procédé PVD comprenant :
- une chambre à vide d'appareil de revêtement ayant une ouverture d'entrée d'un gaz réactif et d'un gaz inerte,
- une première électrode mobile en rotation (1) galvaniquement isolée de la partie restante de l'appareil de revêtement, et reliée à une alimentation en courant (11),
- une seconde électrode mobile en rotation (2) galvaniquement isolée de la partie restante de l'appareil de revêtement, reliée au pôle négatif d'une alimentation permettant d'obtenir un arc basse pression (9), cette seconde électrode étant consommée par l'arc,
la première électrode mobile en rotation (1) et la seconde électrode mobile en rotation (2) étant chacune équipée d'un écran de protection (4), et
- l'appareil comprenant en outre une alimentation en haute-tension (12), dont le pôle négatif est relié aux échantillons ou aux substrats,
**caractérisé en ce que**
la première électrode mobile en rotation (1) est reliée au pôle positif de l'alimentation en courant (11) et les écrans de protection (4) sont des écrans de protection mobiles en rotation.

2. Appareil conforme à la revendication 1,
**caractérisé en ce que**
le pôle négatif de l'alimentation en courant (11) est relié à la chambre à vide de l'appareil de revêtement.

3. Appareil conforme à la revendication 1,
**caractérisé en ce que**
le pôle positif de l'alimentation permettant d'obtenir un arc basse tension (9) est relié à la chambre à vide de l'appareil de revêtement.

4. Appareil conforme à la revendication 1,
**caractérisé en ce que**
le pôle positif de l'alimentation en haute tension (12) est relié à la chambre à vide de l'appareil de revêtement.

5. Appareil conforme à la revendication 1,
**caractérisé en ce que**
l'alimentation en courant (11) est une alimentation en courant pulsé.

6. Appareil conforme aux revendications 1 à 5,
**caractérisé en ce que**
l'écran de protection mobile en rotation de la seconde électrode mobile en rotation (2) est destiné à protéger cette électrode dans la direction des échantillons ou des substrats lors de la combustion de l'arc sur celle-ci.

7. Appareil conforme aux revendications 1 à 5,
**caractérisé en ce que**
l'écran de protection mobile en rotation de la première électrode (1) est destiné à ne pas protéger cette électrode dans la direction des échantillons ou des substrats lors de la combustion de l'arc et peut être utilisé pour permettre le dépôt de revêtements sur des échantillons ou substrats.

8. Appareil conforme aux revendications 1 à 5,
**caractérisé en ce que**
la première électrode mobile en rotation (1) reliée au pôle positif de l'alimentation en courant peut être alternativement rebranchée sur un pôle négatif d'une autre alimentation permettant d'obtenir un arc bassepression (10) et peut être utilisée pour permettre le dépôt de revêtements sur des échantillons ou des substrats.

9. Appareil conforme à la revendication 5 ou aux revendications 6 à 8, lorsque ces revendications dépendent de la revendication 5,
**caractérisé en ce que**
l'alimentation en courant pulsé (11) est destinée à générer des impulsions ayant une durée de 0,1 à 0,000001s et une fréquence de commutation de 10 à 10⁶ Hz.

10. Procédé de décharge luminescente dans un appareil de revêtement par dépôt physique en phase vapeur (PVD) conforme aux revendications 1 à 9, cet appareil ayant une porte, ce procédé comprenant des étapes consistant à :
- actionner l'appareil de sorte que l'arc de la seconde électrode (2) brûle directement jusqu'à la porte selon le mode d'obturation virtuel, l'écran de protection de la première électrode (1) étant ouvert et l'écran de protection (4) de la seconde électrode (2) étant fermé,
- appliquer un potentiel positif sur la première électrode (1) de sorte qu'un potentiel soit appliqué entre l'électrode cible (2) et la première électrode (1),
le potentiel positif appliqué à la première électrode (1) étant choisi de sorte que le faisceau électronique ne brûle plus contre la porte lorsque les électrons sont soumis au potentiel plus élevé appliqué à la première électrode (1).

11. Procédé conforme à la revendication 10,
**caractérisé en ce que**
l'actionnement de l'appareil selon lequel l'arc de la seconde électrode brûle directement vers la porte dans le mode d'obturation virtuel est mis en oeuvre sous approximativement -20V et 100A.

12. Procédé conforme à la revendication 10 ou 11,
**caractérisé en ce que**
le potentiel positif appliqué à la première électrode (1) est approximativement de 1 à 50 V de sorte que le potentiel entre la seconde électrode (2) et la première électrode (1) soit égal à approximativement 20 V à 50 V.

13. Procédé conforme à l'une quelconque des revendications précédentes 10 à 12,
**caractérisé en ce que**
la première électrode (1) est une cible en aluminium, la seconde électrode (2) est une cible en titane et le gaz de process dans l'appareil est de l'argon.

14. Procédé conforme à l'une quelconque des revendications précédentes 10 à 13,
**caractérisé en ce que**
l'écran de protection mobile en rotation de la seconde électrode mobile en rotation (2) est positionné par rotation de façon à protéger cette électrode en direction des échantillons ou des substrats tandis que l'arc brûle sur celle-ci, tandis que l'écran de protection mobile en rotation de la première électrode mobile en rotation (1) est positionné par rotation de sorte qu'il ne protège pas cette électrode en direction des échantillons ou des substrats au cours de la combustion de l'arc de façon à permettre de déposer des revêtements sur des échantillons ou des substrats.
